# EUROPEAN PATENT APPLICATION

(11) **EP 1 793 589 A1**
(43) Date of publication of application: **06.06.2007**
(21) Application number: 06119875.0
(22) Date of filing: 31.08.2006
(51) Int. Cl.: H04N 5/225, H01L 27/146

(54) **Camera module**

(30) Priority: 30.11.2005 JP 2005346712
(71) Applicant: Mitsumi Electric Co., Ltd., Tama-Shi, Tokyo (JP)
(72) Inventor: Shibata, Hisashi Mitsumi Electric Co., Ltd., Yamagata-shi Yamagata (JP); Sato, Toshihiko Mitsumi Electric Co., Ltd., Yamagata-shi Yamagata (JP)
(74) Representative: Patentanwälte Dr. Solf & Zapf

(57) **Abstract**

A camera module (1) having a relatively compact size and adapted to be equipped in camera-equipped electronic apparatuses such as a cellular phone and the like is provided. The camera module (1) includes a lens unit (2) which holds at least one lens (1a, 1b); an image pickup device (5) provided below the lens unit (2), the image pickup device (5) having a bottom surface, and the image pickup device (5) including a substantially planar ground (5a) provided over roughly the entire of the bottom surface thereof; and a substrate (6) provided on the side of the bottom surface of the image pickup device (5), the substrate (6) having an upper surface, and the substrate (5) including a grounding land (6a) having substantially the same shape and size as those of the ground (5a) of the image pickup device (5) and formed so as to have a lattice pattern. The ground (5a) of the image pickup device (5) is bonded to the grounding land (6a) of the substrate (6) via a conductive adhesive so that the ground (5a) of the image pickup device (5) and the grounding land (6a) of the substrate (6) are electrically connected to each other.

## Description

### BACKGROUND OF THE INVENTION

### Field of the Invention

The present invention relates to a camera module, and more specifically to a camera module having a relatively compact size and adapted to be equipped in camera-equipped electronic apparatuses such as a cellular phone and the like.

### Description of the Related Art

In a camera module having a relatively compact size and adapted to be equipped in camera-equipped electronic apparatuses such as a cellular phone and the like, a CMOS sensor or a CCD sensor is used as an image pickup device.

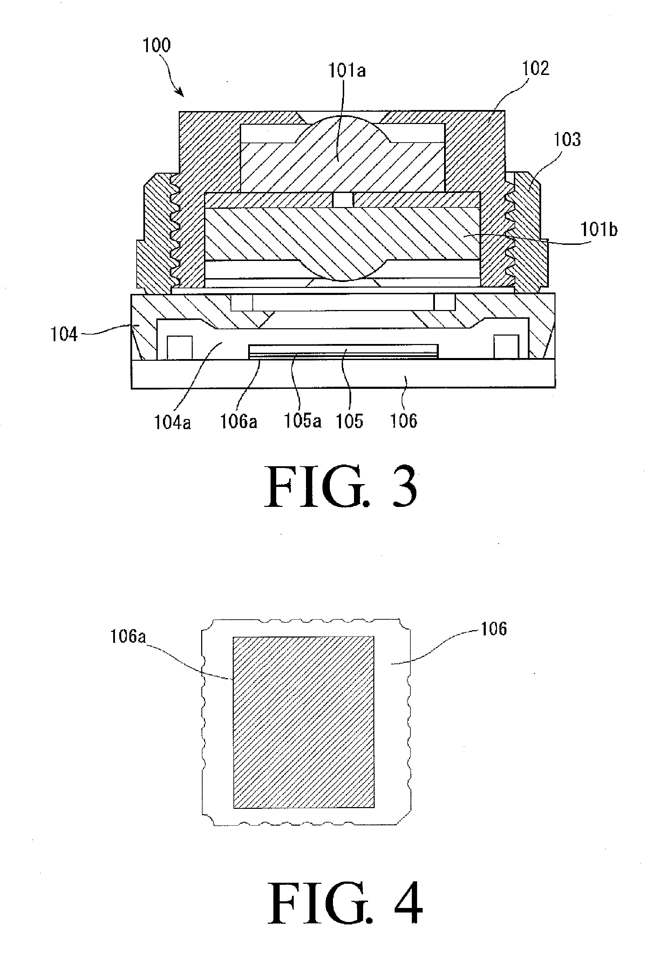

FIG. 3 is a cross sectional view showing a prior art camera module 100. The camera module 100 is composed from a lens unit 102 which includes lenses 101a, 101b, a lens holder 103 in which the lens unit 102 is rotatably threaded for holding the lens unit 102, a base 104 on which a bottom of the holder 103 is bonded, an image pickup device 105 provided inside an image pickup device housing space 104a of the base 104 so that it is positioned below the lens unit 102, and a substrate 106 on which the image pickup device 105 is mounted. The image pickup device 105 is a CMOS sensor or a CCD sensor. The bottom of the base 104 is bonded to the peripheral edges of the upper surface of the substrate 106.

On the bottom surface of the image pickup device 105, a planar ground 105a having a substantially square shape is provided. Further, on the upper surface of the substrate 106, a planar land for ground (hereinafter, referred to as "planar grounding land") 106a having a substantially square shape is also provided (see FIG. 4). The size and shape of the ground 105a of the image pickup device 105 are substantially the same as those of the grounding land 106a of the substrate 106.

The ground 105a of the image pickup device 105 is provided on the grounding land 106a of the substrate 106 via a conductive adhesive in a surface to surface manner so that the ground 105 of the image pickup device 105 and the grounding land 106a of the substrate 106 are electrically connected to each other.

The camera module 100 described above is mounted in an electronic apparatus such as a cellular phone and the like, and thus there is a problem in that an image taken by the camera module 100 is likely to be affected by driving frequencies (clock) generated inside the electronic apparatus. Namely, there is a case that an image noise is generated in an image taken by the image pickup device 105 of the camera module 100 due to electromagnetic waves generated by the driving frequencies. In more details, in the camera module 1, the image pickup device 100 produces only an extremely small quantity of electric charges by photoelectric conversion, there is a case where the grounding land 106a of the substrate 106 cannot keep a stable potential due to the affect of the electromagnetic waves, thereby an image noise being generated. Further, such an image noise is also generated in the case where it is not possible to shield the electromagnetic waves adequately.

In addition, in the camera module 100 described above, there is another problem in that since the grounding land 106a of the substrate 106 has a planar shape (flat surface), there is a case that adhesive force by the conductive adhesive cannot be exhibited sufficiently. This is because the conductive adhesive can exhibit sufficient adhesive force against the substrate 106 formed of a resin material while it cannot exhibit sufficient adhesive force against the grounding land made of a metallic material.

### SUMMARY OF THE INVENTION

The present invention has been made in view of the above problems, and therefore it is an object of the present invention to provide a camera module which can prevent an affect by electromagnetic waves to the image pickup device of the camera module and which can ensure adhesive strength between the image pickup device and the substrate.

In order to achieve the above object, the present invention is directed to a camera module which comprises a lens unit which holds at least one lens; an image pickup device provided below the lens unit, the image pickup device having a bottom surface, and the image pickup device including a substantially planar ground provided over roughly the entire of the bottom surface thereof; and a substrate provided on the side of the bottom surface of the image pickup device, the substrate having an upper surface, and the substrate including a grounding land having substantially the same shape and size as those of the ground of the image pickup device and formed so as to have a lattice pattern. The ground of the image pickup device is bonded to the grounding land of the substrate via a conductive adhesive so that the ground of the image pickup device and the grounding land of the substrate are electrically connected to each other.

As described above, the feature of the camera module of the present invention resides in the structure that the substrate includes a grounding land having substantially the same shape and size as those of the ground of the image pickup device and formed so as to have a lattice pattern.

Accordingly, the total area of the grounding land is reduced as compared to the prior art in which the grounding land is formed into a planar shape (flat surface). Therefore, in this invention, the quantity of electrical charges per unit area is increased as compared to the prior art camera module. Due to the increased quantity of electrical charges, the electrical potential of the grounding land of the substrate is difficult to be affected by electromagnetic waves generated by the driving frequencies generated inside the electronic apparatus such as a cellular phone and the like to which the camera module is mounted. In more detail, in the case where the grounding land is formed into a planar shape (flat surface), electrical charges are dispersed over the entire of the grounding land so that changes in the potential of the grounding land are likely to occur by the affect of the electromagnetic waves. However, by forming the grounding land of the substrate so as to have a lattice pattern as the present invention, the quantity of electrical charges per unit area is increased, it is possible to prevent the potential of the grounding land from being changed by the electromagnetic waves. Therefore, it is possible to prevent an image noise from being generated in an image taken by the image pickup device of the camera module by electromagnetic waves generated by the driving frequencies.

In addition, the grounding land is formed to have a lattice pattern having a number of unit cells, the surface of the substrate is exposed from unit cells. As a result, at the portions of the unit cells, the adhesive force of the conductive adhesive is increased, and thus it is possible to bond the image pickup device against the substrate more firmly.

Further, in the camera module according to the present invention, it is preferred that the grounding land of the substrate having the lattice pattern includes a number of unit cells, and the unit cells of the grounding land are uniformly distributed over roughly the entire of the grounding land of the substrate.

According to the above structure, since uneven distribution of electrical charges in the grounding land of the substrate is prevented, it is possible to provide a stable ground function. As a result, it is possible to reliably prevent an image noise from being generated in an image taken by the image pickup device due to the electromagnetic waves.

Furthermore, in the camera module according to the present invention, it is preferred that the image pickup device is a CMOS sensor or CCD sensor.

These and other structures, operations and effects of the present invention will be apparent when the following description of the preferred embodiments are considered taken in conjunction with the appended drawings.

### BRIEF DESCRIPTION OF THE DRAWINGS

FIG. 1 is a cross sectional view showing a camera module 1 according to the embodiment of the present invention.
FIG. 2 is a top plan view of a substrate 6 of the camera module 1 shown in FIG. 1.
FIG. 3 is a cross sectional view showing a prior art camera module 100.
FIG. 4 is a top plan view of a substrate 106 of the prior art camera module 1 shown in FIG. 3.

### DETAILED DESCRIPTION OF THE INVENTION

Hereinbelow, a camera module 1 according to the first embodiment of the present invention will be described in detail with reference to the appended drawings. In this regard, it is to be noted that since the camera module 1 is to be equipped in small electronic apparatuses such as a cellar phone, it has a particularly compact size, for example, 6 mm in length, 6 mm in width and 4.5 mm in height.

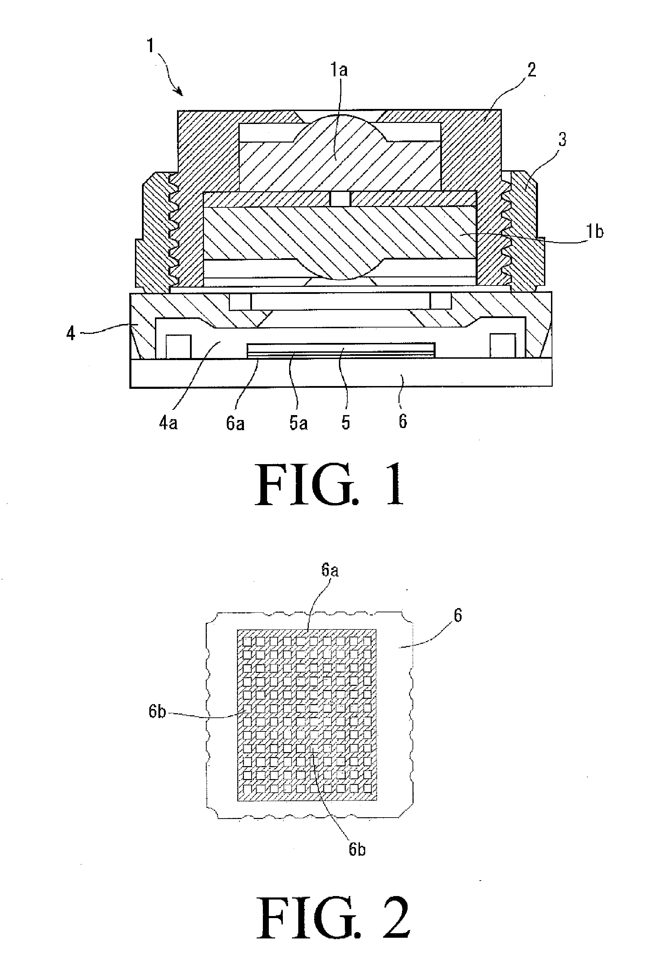

FIG. 1 is a cross sectional view showing the camera module 1 according to the embodiment of the present invention. The camera module 1 is composed from a lens unit 102 which includes lenses 1a, 1b, a lens holder 3 in which the lens unit 2 is rotatably threaded for holding the lens unit 2, a base 4 on which a bottom of the holder 3 is bonded, an image pickup device 5 provided inside an image pickup device housing space 4a of the base 4 so that it is positioned below the lens unit 2, and a substrate 6 on which the image pickup device 5 is mounted. The bottom of the base 4 is bonded to the peripheral edges of the upper surface of the substrate 6.

On roughly the entire of the bottom surface of the image pickup device 5, a planar ground 5a having a substantially square shape is provided. Further, on the upper surface of the substrate 6, a planar land for ground (hereinafter, referred to as "planar grounding land") 6a having a substantially square shape is also provided. The size and shape of the ground 5a of the image pickup device 5 are substantially the same as those of the grounding land 6a of the substrate 6. The ground 5a of the image pickup device 5 is provided on the grounding land 6a of the substrate 6 via a conductive adhesive in a surface to surface manner so that the ground 5 of the image pickup device 105 and the grounding land 6a of the substrate 6 are electrically connected to each other.

In more details, the image pickup device 5 is a CMOS sensor or a CCD sensor, and the ground 5c formed on the bottom surface of the image pickup device 5 has a substantially square planar shape.

Further, as shown in FIG. 2, the grounding land 6a formed on the upper surface of the substrate 6 is formed so as to have a lattice pattern. The size and shape of the grounding land 6a of the substrate 6 are substantially the same as those of the ground 5a of the image pickup device 5.

As shown in FIG. 2, the grounding land 6a of the substrate 6 includes a number of unit cells 6b. In the example shown in FIG. 2, the unit cells 6b include 120 unit cells arranged in a matrix comprised of 10 unit cells in each of the rows and 12 unit cells in each of the columns so that these unit cells are uniformly distributed over roughly the entire of the grounding land 6a of the substrate 6.

As shown in the drawing, in this embodiment, each of the unit cells 6b is formed into a substantially square shape. However, the present invention is not limited thereto, and each of the unit cells 6b may be formed into other shapes such as a circular shape. Further, as shown in the drawing, in this embodiment, the unit cells 6b are arranged in a matrix. However, the present invention is not limited thereto, and

The ground 5a of the image pickup device 5 is bonded to the grounding land 6a of the substrate 6 through a conductive adhesive in a face to face manner so that the ground 5a of the image pickup device 5 is electrically connected to the grounding land 6a of the substrate 6 through the conductive adhesive.

Hereinbelow, the operation and result of the camera module of this embodiment will be described.

As described above, in the camera module of the embodiment, on roughly the entire of the bottom surface of the image pickup device 5, the planar ground 5a having a substantially square shape is provided, and on the upper surface of the substrate 6, the planar grounding land 6a having a substantially square shape and formed so as to have a lattice pattern is also provided. The size and shape of the ground 5a of the image pickup device 5 are substantially the same as those of the grounding land 6a of the substrate 6. The ground 5a of the image pickup device 5 is provided on the grounding land 6a of the substrate 6 via a conductive adhesive in a surface to surface manner so that the ground 5 of the image pickup device 105 and the grounding land 6a of the substrate 6 are electrically connected to each other.

Since the planar grounding land 6a has a substantially square shape and it is formed so as to have a lattice pattern, the total area of the grounding land 6a is reduced as compared to the prior art in which the grounding land 106a is formed into a planar shape (flat surface). Therefore, in this embodiment, the quantity of electrical charges per unit area is increased as compared to the prior art camera module. Due to the increased quantity of electrical charges, the electrical potential of the grounding land 6a of the substrate 6 is difficult to be affected by electromagnetic waves generated by the driving frequencies generated inside the electronic apparatus such as a cellular phone and the like to which the camera module is mounted. In more detail, in the case where the grounding land 6a is formed into a planar shape (flat surface), electrical charges are dispersed over the entire of the grounding land so that changes in the potential of the grounding land are likely to occur by the affect of the electromagnetic waves. However, by forming the grounding land of the substrate so as to have a lattice pattern as the present embodiment, the quantity of electrical charges per unit area is increased, it is possible to prevent the potential of the grounding land from being changed by the electromagnetic waves. Therefore, it is possible to prevent an image noise from being generated in an image taken by the image pickup device 5 of the camera module 1 by electromagnetic waves generated by the driving frequencies.

Further, the grounding land 6a is formed to have a lattice pattern having a number of unit cells 6b, the surface of the substrate 6 is exposed from unit cells 6b. As a result, at the portions of the unit cells 6b, the adhesive force of the conductive adhesive is increased, and thus it is possible to bond the image pickup device 5 against the substrate 6 more firmly.

Furthermore, the unit cells 6b of the grounding land 6b of the substrate 6 is uniformly distributed over roughly the entire of the grounding land 6b of sub substrate 6. Therefore, since uneven distribution of electrical charges in the grounding land 6a of the substrate 6 is prevented, it is possible to provide a stable ground function. As a result, it is possible to reliably prevent an image noise from being generated in an image taken by the image pickup device 5 due to the electromagnetic waves.

Moreover, since the unit cells 6b of the grounding land 6 are uniformly distributed over roughly entire of the grounding land 6a of the substrate 6, it is possible to enhance the adhesive strength over the entire of the grounding land 6a uniformly.

Finally, it is also to be understood that the present disclosure relates to subject matter contained in Japanese Patent Application No. 2005-346712 (filed on November 30, 2005 which is expressly incorporated herein by reference in its entirety.

## Claims

1. A camera module (1), comprising:
a lens unit (2) which holds at least one lens (la, 1b);
an image pickup device (5) provided below the lens unit (2), the image pickup device (5) having a bottom surface, and the image pickup device (5) including a substantially planar ground (5a) provided over roughly the entire of the bottom surface thereof; and
a substrate (6) provided on the side of the bottom surface of the image pickup device (5), the substrate (6) having an upper surface, and the substrate (6) including a grounding land (6a) having substantially the same shape and size as those of the ground (5a) of the image pickup device (5) and formed so as to have a lattice pattern,
wherein the ground (5a) of the image pickup device (5) is bonded to the grounding land (6a) of the substrate (5) via a conductive adhesive so that the ground (5a) of the image pickup device (5) and the grounding land (6a) of the substrate (6) are electrically connected to each other.

2. The camera module as claimed in claim 1, wherein the grounding land (6a) of the substrate (6) having the lattice pattern includes a number of unit cells (6b), and the unit cells (6b) of the grounding land (6a) are uniformly distributed over roughly the entire of the grounding land (6a) of the substrate (6).

3. The camera module as claimed in claim 1, wherein the image pickup device (5) is a CMOS sensor or CCD sensor.
